# EUROPÄISCHE PATENTSCHRIFT

(11) **EP 0 548 108 B1**
(45) Veröffentlichungstag und Bekanntmachung des Hinweises auf die Patenterteilung: **25.05.1994**
(21) Anmeldenummer: 91915130.8
(22) Anmeldetag: 29.08.1991
(51) Int. Cl.: G11C 29/00

(54) **SCHALTUNGSANORDNUNG ZUM TESTEN EINES HALBLEITERSPEICHERS MITTELS PARALLELTESTS MIT VERSCHIEDENEN TESTBITMUSTERN**
CIRCUIT ARRANGEMENT FOR TESTING A SEMICONDUCTOR STORE BY MEANS OF PARALLEL TESTS WITH DIFFERENT TEST BIT PATTERNS
CIRCUIT DE TEST DE MEMOIRES SEMI-CONDUCTRICES PAR DES TESTS PARALLELES AVEC DIFFERENTES CONFIGURATIONS BINAIRES DE TEST

(30) Priorität: 11.09.1990 DE 4028819
(43) Veröffentlichungstag der Anmeldung: 30.06.1993
(73) Patentinhaber: SIEMENS AKTIENGESELLSCHAFT, 80333 München (DE)
(72) Erfinder: LUSTIG, Bernhard, Dr., W-8000 München 83 (DE)
(86) Internationale Anmeldenummer: DE9100685
(87) Internationale Veröffentlichungsnummer: WO9204717

(56) Entgegenhaltungen:
- EP-A- 0 263 470
- PROCEEDINGS OF THE INTERNATIONAL TEST CONFERENCE, 29-31 August 1989, Seiten 322-326, IEEE; New York, US; Y. MATSUDA et al.: "A new array architecture for parallel testing in VLSI memories"
- PROCEEDINGS OF THE INTERNATIONAL TEST CONFERENCE, 1-3 September 1987, Seiten 1066-1071, IEEE; new York, US; J. INOUE et al.: "Parallel testing technology for VLSI memories"
- IEEE TRANSACTIONS ON COMPUTERS, Bd. 38, Nr. 3, März 1989, New York, US, Seiten 394-407; P. MAZUMDER et al.: "Parallel testing for pattern-sensitive faults in semiconductor random-acess memories"

## Beschreibung

Die Erfindung betrifft eine Schaltungsanordnung zum Testen eines Halbleiterspeichers mittels Paralleltests mit verschiedenen Testbitmustern zum Testen von Halbleiterspeichern nach dem Oberbegriff des Patentanspruchs 1.

Eine Schaltungsanordnung dieser Art ist aus der Veröffentlichung mit dem Titel "A 60-ns 3.3-V-Only 16-Mbit DRAM with Multipurpose Register" von K. Arimoto et al. (Mitsubishi Electric Corporation) aus IEEE Journal of Solid-State Circuits, Vol. 24, No. 5, Oktober 1989 (Seite 1184 bis 1190) bekannt. Dabei handelt es sich um eine Schaltungsanordnung für einen parallelen line-mode-Test (LMT), bei dem zufällige Bitmuster in ein Multi-Purpose-Register (MPR) und in Speicherzellen geschrieben, die ausgelesenen Bitmuster dieser Speicherzellen mit den Bitmustern des MPR's in Vergleicherschaltungen verglichen und die Signale der Vergleicherausgänge mit einer Wired-OR-Verknüpfung zusammengefaßt werden, um beim Auftreten eines Fehlers die adressierte Wortleitung auf eine Ersatz-wortleitung (Redundanz) umzuschalten.

Der Erfindung liegt die Aufgabe zugrunde, eine Schaltungsanordnung anzugeben, die mit minimalem Aufwand eine Lokalisierung fehlerhafter Einzelspeicherzellen oder Speicherzellen-n-Tupel erlaubt. Die Lokalisierung fehlerhafter Speicherzellen-n-Tupel kann dazu dienen, daß Speicherzugriffe auf fehlerhafte Speicherzellen-n-Tupel auf fehlerfreie Speicherzellen-n-Tupel (Redundanzadresse) umsteuerbar sind.

Die Aufgabe wird erfindungsgemäß durch die in dem kennzeichnenden Teil des Patentanspruchs 1 angegebenen Merkmale gelöst.

Der mit der Erfindung erzielbare Vorteil liegt insbesondere darin, daß bei der nach der Erfindung ausgebildeten Schaltungsanordnung eine bessere Fehlerlokalisation als bei der bekannten Schaltungsanordnung ermöglicht ist, daß dabei Einzelfehler von Mehrfachfehlern unterscheidbar sind und daß durch eine erfindungsgemäße Vergleicherschaltung keine CMOS-Pegel, sondern nur einige zehn Millivolt auf den, mit den Eingängen der Vergleicherschaltung verbundenen, Datenleitungen erforderlich sind.

Die Patentansprüche 2 bis 8 sind auf bevorzugte Ausbildungen der erfindungsgemäßen Schaltungsanordnung gerichtet.

Die Erfindung wird nachfolgend anhand der Zeichnung näher erläutert. Dabei zeigt
- Figur 1: ein Blockschaltbild eines Halbleiterspeichers zur Erläuterung der prinzipiellen Funktionsweise der erfindungsgemäßen Schaltungsanordnung,
- Figur 2: ein Schaltbild einer Anordnung mit vier Vergleicherschaltungen,
- Figur 3: ein Schaltbild einer Anordnung mit vier Vergleicherschaltungen in Form von Paritätsdreherschaltungen,
- Figur 4: ein detailliertes Schaltbild eines in Figur 3 gezeigten Differenzverstärkers,
- Figur 5: ein Schaltbild einer Zusammenfassung von Vergleicherausgängen durch vier Wired-OR-Leitungen,
- Figur 6: ein Schaltbild einer Fehleradreßmatrix mit Paaren von Wired-OR-Leitungen einer erfindungsgemäßen Schaltungsanordnung,
- Figur 7: ein Schaltbild einer erfindungsgemäßen Schaltungsanordnung, die eine Fehlertyperkennungsschaltung mit Einzelfehlererkennung bei gleichzeitiger Invertierung eines Fehleradreßsignals beinhaltet,
- Figur 8: ein Schaltbild einer Schaltungsanordnung, die eine Redundanzadreßmatrix mit Paaren von Wired-OR-Leitungen und eine nachgeschaltete Fehlertyperkennungsschaltung mit Einzel- und Mehrfachfehlererkennungen bei gleichzeitiger Invertierung eines Fehleradreßsignals beinhaltet.

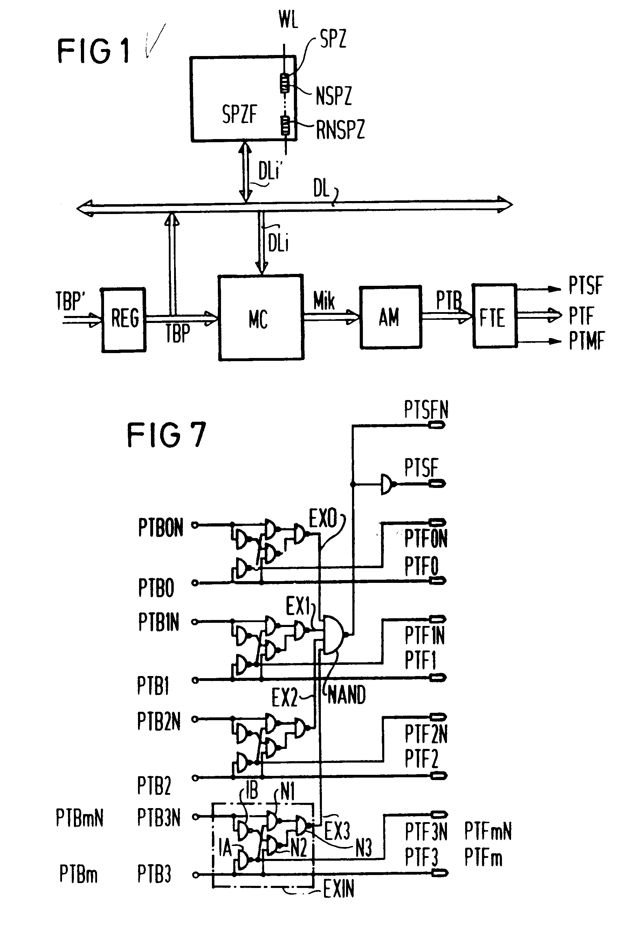

In dem in Figur 1 gezeigten Blockschaltbild eines Halbleiterspeichers ist vereinfacht ein aus Einzelspeicherzellen SPZ aufgebautes Speicherzellenfeld SPZF dargestellt, wobei Einzelspeicherzellen SPZ mit gemeinsamer Wortleitung WL zu Speicherzellen-n-Tupeln NSPZ gruppiert und im Fehlerfall durch redundante Speicherzellen-n-Tupel RNSPZ der Wortleitung WL ersetzbar sind. Die Adressierung der Einzelspeicherzellen SPZ erfolgt durch die Wortleitung WL und durch Bitleitungen, wobei jeweils nur eine Auswahl von Bitleitungen auf übergeordneten Datenleitungen DL einer hierarchischen Datenbusstruktur verfügbar ist. Ein Datenfluß zwischen dem Speicherzellenfeld SPZF und den übergeordneten Datenleitungen DL ist durch Datenleitungen DLi' und ein Datenfluß zwischen den übergeordneten Datenleitungen DL und einer Vielzahl von Vergleicherschaltungen MC ist durch Datenleitungen DLi möglich. Die Vielzahl von Vergleicherschaltungen sind, wie das ihnen vorgeschaltete Register REG, bereits Bestandteil einer On-Chip-Schaltungsanordnung zum Testen des Halbleiterspeichers. Das Register REG steht stellvertretend für gegebenenfalls mehrere n-Bit breite Register und weist die Registereingänge TBP' und die Registerausgänge TBP auf, wobei die Registerausgänge sowohl mit der Vielzahl von Vergleicherschaltungen MC als auch mit den übergeordneten Datenleitungen DL verbunden sind. Mehrere Register können moglicherweise aus Designgründen oder aber zum Testen mit unterschiedlichen Testmustern erforderlich sein. Eine der Vielzahl von Vergleicherschaltungen MC nachgeschaltete, erfindungsgemäße Adreßmatrix AM faßt Vergleicherausgänge Mik in Form von Wired-OR-Leitungen PTB zusammen und eine der Adreßmatrix AM nachgeschaltete, erfindungsgemäße Fehlertyperkennungsschaltung FTE liefert Adreßausgänge PTF, einen Einzelfehlerausgang PTSF und einen Mehrfachfehlerausgang PTMF.

Um einen Halbleiterspeicher zu testen, wird über die Registereingänge TBP' ein beliebiges Testmuster in das n-Bit breite Register REG eingeschrieben. Befindet sich ein bestimmtes Testmuster im Register REG, so wird dieses Testbitmuster von den Registerausgängen TBP über die Datenleitungen DL und DLi' in eine Vielzahl von Speicherzellen-n-Tupel mit gemeinsamer Wortleitung WL kopiert. Ist dies geschehen, so werden die Bitmuster der Vielzahl von Speicherzellen-n-Tupeln, die sich aufgrund von Speicherfehlern jeweils von dem Testbitmuster unterscheiden können, über die Datenleitungen DLi', DL, DLi der Vielzahl von Vergleicherschaltungen zugeführt, wo sie mit dem an den Registerausgängen TBP zur Verfügung stehenden Testbitmuster verglichen werden. Unterscheidet sich ein Bitmuster von dem Testbitmuster so liegt sicher ein Fehler vor. Der Umkehrschluß der Aussage ist nicht zulässig, da aufgrund eines ungünstig gewählten Testmusters Fehler, wie zum Beispiel Kurzschlüsse zwischen benachbarten Speicherzellen, nicht erkannt werden. Wären jetzt alle Vergleicherausgänge Mik durch eine Wired-OR-Leitung zusammengefaßt, so wäre nur eine relativ grobe Fehlerlokalisierung durch die Wortleitung WL möglich. Wird jedoch, wie in Figur 1 gezeigt, eine Adreßmatrix AM mit mehreren Wired-OR-Leitungen PTB zur Zusammenfassung der Vergleicherausgänge Mik verwendet, so können fehlerhafte Speicherzellen-n-Tupel NSPZ oder fehlerhafte Einzelspeicherzellen SPZ lokalisiert werden. Aus den Signalen der Wired-OR-Leitungen PTB werden durch logische Verknüpfungen der Fehlertyperkennungsschaltung FTE jeweils ein Einzelfehlersignal und ein Mehrfachfehlersignal gebildet und den entsprechenden Ausgängen PTSF und PTMF zugeführt.

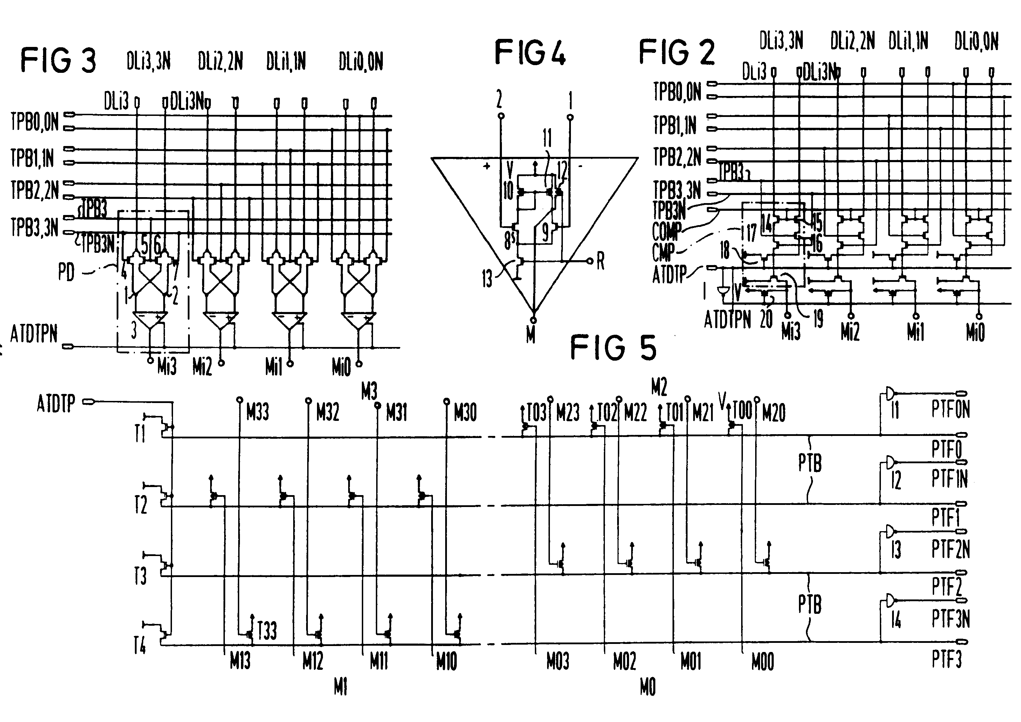

Figur 2 zeigt eine Anordnung aus vier Vergleicherschaltungen zum Testen von Halbleiterspeichern, wobei Datenleitungspaare DLiO,ON ... DLi3,3N mit Registerausgangspaaren TPBO,ON ... TBP3 , 3N vergleichbar sind und die Vergleicher die Vergleicherausgänge Mi0 ... Mi3 besitzen. Eine einzelne Vergleicherschaltung besteht dabei im wesentlichen aus einem Komparator CMP, der auch bei der eingangs zitierten Schaltungsanordnung von Arimoto et al. Anwendung findet. Der Komparator CMP besteht aus sechs n-Kanal MOS-Transistoren 14 bis 19, wobei eine Reihenschaltung aus den Transistoren 14 und 17 eine Datenleitung DLi3 und eine Reihenschaltung aus den Transistoren 15 und 16 eine Datenleitung DLi3N, die das invertierte Signal der Datenleitung DLi3 führt, mit dem Gate des Transistors 19 verbindet. Das Gate des Transistors 16 ist mit einem Registerausgang TPB3 und das Gate des Transistors 17 ist mit einem Registerausgang TPB3N, der das invertierte Signal des Registerausgangs TPB3 führt, verbunden. Die beiden Gates der Transistoren 14 und 15 werden über eine Steuerleitung COMP angesteuert und das Gate des Transistors 18, der das Gate des Transistors 19 auf Bezugspotential durchschaltet, wird über eine weitere Steuerleitung ATDTP angesteuert. Der Transistors 19 liegt zwischen Bezugspotential und einem Vergleicherausgang Mi3, der über einen p-Kanal-MOS-Transistor 20 mit einer Versorgungsspannung V verbunden ist. Das Gate des Transistors 20 ist mit einer Steuerleitung ATDTPN verbunden, die ihrerseits über einen Inverter I mit der Steuerleitung ATDTP verbunden ist.

Führt beispielsweise die Datenleitung DLi3 High-Potential und damit die Datenleitung DLi3N Low-Potential, so kann, wenn die Steuerleitung COMP High-Potential führt, das Gate des Transistors 19 nur dann High-Potential erhalten, wenn der Registerausgang TPB3N High-Potential und damit der Registerausgang TPB3 Low-Potential führt. Entsprechendes gilt für den Fall, daß die Datenleitung DLi3 Low-Potential und der Registerausgang TPB3 High-Potential führen. Das Gate des Transistors 19 erhält also nur dann High-Potential wenn ein Testbit aus dem Register mit dem Bit einer ausgelesenen Speicherzelle nicht übereinstimmt. Der Transistors 19 wird hierbei leitend und der Vergleicherausgang Mi3 erhält im Fehlerfall Low-Potential. Ein Reset der Vergleicherschaltung wird dadurch bewirkt, daß die Steuerleitung ATDTP High-Potential erhält, damit der Transistor 18 leitend wird, wodurch das Gate des Transistors 19 Low-Potential erhält und den Transistor 19 dadurch sperrt. Über den Inverter I erhält die Steuerleitung ATDTPN Low-Potential, wodurch der Transistor 20 leitend wird und der Vergleicherausgang Mi3 definiert High-Potental erhält.

Figur 3 zeigt eine Anordnung aus vier Vergleicherschaltungen einer erfindungsgemäßen Schaltungsanordnung zum Testen von Halbleiterspeichern, wobei Signale von Datenleitungspaare DLi0,ON ... DLi3,3N mit Signalen von Registerausgangspaaren TPB0,ON ... TPB3,3N vergleichbar sind und die Vergleicherschaltungen Vergleicherausgänge Mi0 ... Mi3 besitzen. Eine einzelne Vergleicherschaltung wird hierbei durch eine aus vier n-Kanal-MOS-Transistoren 4 bis 7 und einem Differenzverstärker 3 bestehende Paritätsdreherschaltung PD gebildet. Bei dieser Paritätsdreherschaltung ist eine Datenleitung DLi3 über den Transistor 4 auf den invertierenden Eingang 1 und über den Transistor 5 auf den nicht invertierenden Eingang 2 des Differenzverstärkers 3 durchschaltbar. Entsprechend ist auch die das invertierte Signal der Datenleitung DLi3 führende Datenleitung DLi3N über den Transistor 6 auf den invertierenden Eingang 1 und über den Transistor 7 auf den nicht invertierenden Eingang 2 des Differenzverstärkers 3 durchschaltbar. Hierzu sind die Gates der Transistoren 5 und 6 mit dem Registerausgang TPB3 und die Gates der Transistoren 4 und 7 mit dem invertierten Signal des Registerausgangs TPB3 führenden Registerausgang TPB3N verbunden. Der Differenzverstärker 3, dessen Ausgang der Vergleicherausgang Mi3 ist, weist einen Reseteingang auf, der mit einer Steuerleitung ATDTPN verbunden ist.

Führt die Datenleitung DLi3 High-Potential und somit die Datenleitung DLi3N Low-Potential, so gelangt im Fehlerfall, also wenn der Registerausgang TPB3 Low-Potential und der Registerausgang TPB3N High-Potential führt, High-Potential über den Transistor 4 an den invertierenden Eingang 1 und Low-Potential über den Transistor 7 an den nicht invertierenden Eingang 2 des Differenzverstärkers 3. Der Differenzverstärker 3 invertiert (dreht) im Fehlerfall das Signal der Datenleitung DLi3 und nimmt an seinem Ausgang Mi3 Low-Potential an. Tritt kein Fehler auf, so werden die Transistoren 5 und 6 leitend, der Differenzverstärker invertiert nicht und der Ausgang Mi3 des Differenzverstärkers 3 nimmt High-Potential an.

In Figur 4 ist der in Figur 3 gezeigte Differenzverstärker näher ausgeführt. Der Differenzverstärker besitzt einen invertierenden Eingang 1, einen nicht invertierenden Eingang 2, einen Reseteingang R, einen Ausgang M und ist aus drei n-Kanal-MOS-Transistoren 8, 9 und 13 und aus drei p-Kanal MOS-Transistoren 10, 11 und 12 aufgebaut, wobei jeweils der Drainanschluß des Transistors 10, 11 und 12 mit einer Versorgungsspannung V verbunden ist. Die Transistoren 8 bis 11 bilden eine Brückenschaltung, wobei die Transistoren 10, 11 als Lastelemente dienen. Die Sourceanschlüsse der Transistoren 8, 9 sind mit den Drainanschlüssen des Transistors 13 verbunden, der seinerseits mit seinem Sourceanschluß mit Bezugspotential verbunden ist. Das Gate des Transistors 8 ist mit dem nicht invertierenden Eingang 2 und das Gate des Transistors 9 ist mit dem invertierenden Eingang 1 verbunden. Der Verbindungsknoten zwischen dem Transistor 8 und dem als Lastelement dienenden Transistor 10 ist mit den Gates der Transistoren 10 und 11 verbunden, und der Verbindungsknoten zwischen dem Transistor 9 und dem als Lastelement dienenden Transistor 11 ist als Verstärkerausgang M herausgeführt. Ein Reseteingang R ist mit dem Gate des Transistors 13 und dem Gate des Transistors 12 verbunden, wobei der Transistor 12 zum Transistor 11 parallel geschaltet ist.

Wird der Eingang 1 auf High-Potential und der Eingang 2 auf Low-Potential gelegt, so wird der Transistor 9 leitend und der Transistor 8 sperrend, wodurch am Ausgang M Low-Potential anliegt. Wird der invertierende Eingang 1 auf Low-Potential und der nicht invertierende Eingang 2 auf High-Potential gelegt, so wird der Transistor 9 sperrend und der Transistor 8 leitend, wodurch am Ausgang M High-Potential anliegt. Um ein Reset zu bewirken wird der Reseteingang R von High-Potential auf Low-Potential geschaltet, dadurch sperrt der Transistor 13 und der Ausgang M wird niederohmig mit der Versorgungsspannung V verbunden und auf High-Potential gelegt.

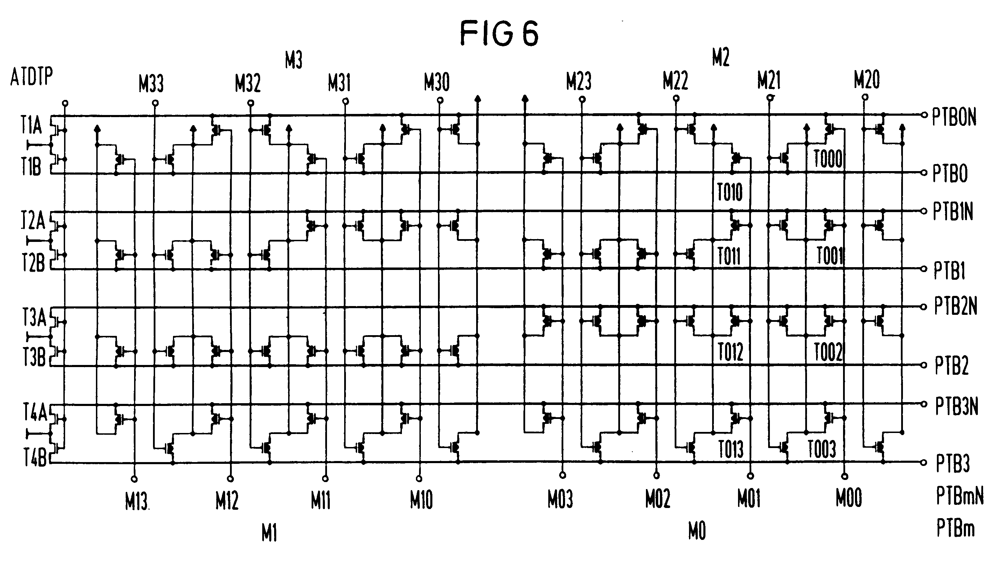

Bei dem in Figur 5 dargestellten Schaltbild handelt es sich um eine Zusammenfassung von Vergleicherausgängen M00 ... M33 durch Wired-OR-Leitungen PTB, wobei zur besseren Fehlerlokalisierung vier Wired-OR-Leitungen vorgesehen sind und eine Verknüpfung nicht, wie bei Arimoto et al., durch einfaches Verbinden von Leitungen, sondern über p-Kanal-Schalttransistoren T00 ... T33 erfolgt. Die Vergleicherausgänge M00 ... M03 bilden beispielsweise ein Quadrupel M0 und sind mit den Gates der Transistoren T00 ... T03 verbunden, die ihrerseits jeweils mit ihrem Sourceanschluß mit der Versorgungsspannung V und mit ihrem Drainanschluß mit einer Wired-OR-Leitung verbunden sind, wobei die Wired-OR-Leitung mit einem Adreßausgang PTF0 verbunden ist. Die mit dem Adreßausgang PTF0 verbundene Wired-OR-Leitung ist durch einen n-Kanal-Schalttransistor T1, dessen Gate mit einer Steuerleitung ATDTP verbunden ist, auf Bezugspotential schaltbar und über einen Inverter I1 mit einem Adreßausgang PTF0N verbunden. In entsprechender Weise, ist je ein weiteres Quadrupel M1 bis M3 mit genau einer Wired-OR-Leitung zum Adreßausgang PTF1 bis PTF3 verbunden, sind diese Wired-OR-Leitungen jeweils durch Transistoren T2 bis T4 auf Bezugspotential schaltbar und sind diese Wired-OR-Leitungen über Inverter I2 bis I4 mit Adreßausgängen PTF1 bis PTF3 verbunden. Da 16 Vergleicherausgänge zu vier Quadrupel zusammengefaßt sind werden 16/4 = 4 Wired-OR-Leitungen, 16 p-Kanal-Schalttransistoren, 16/4 = 4 n-Kanal-Schalttransistoren und 16/4 = 4 Inverter benötigt. Ein Fehler ist bis auf Quadrupel-Ebene lokalisierbar und da jedes Quadrupel einem eigenen Adreßausgang zugeordnet ist, können auch Mehrfachfehler eindeutig zugeordnet werden. Ein entscheidender Nachteil dieser Schaltungsanordnung ist jedoch, daß bei relativ vielen Vergleicherausgänge eine sehr große Zahl an Wired-OR-Leitungen erforderlich ist. Sind beispielsweise 256 Vergleicherausgänge zu Quadrupeln zusammengefaßt, so werden bereits 256/4 = 64 Wired-OR-Leitungen benötigt.

Wenn die Steuersignalleitung ATDTP High-Potential hält, werden die Transistoren 1 bis 4 leitend und die Wired-OR-Leitungen können sich auf Bezugspotential (Low) entladen. Tritt dann beim Test beispielsweise in einem Quadrupel von Vergleicherausgängen M00 ... M03 ein oder mehrere Fehler auf, so ist das Quadrupel MD fehlerhaft und die mit dem Adreßausgang PTF0 verbundene Wired-OR-Leitungen durch mindestens einen der Transistoren T00 ... T03 mit der Versorgungsspannung V verbunden, wodurch der Ausgang PTF0 High-Potential erhält und somit ein fehlerhaftes Quadrupel M0 anzeigt.

Figur 6 zeigt eine Fehleradreßmatrix einer erfindungsgemäßen Schaltungsanordnung zum Testen von Halbleiterspeichern, wobei Vergleicherausgänge durch Paare von Wired-OR-Leitungen PTBm, PTBmN so zusammengefaßt werden, daß eine Fehlerlokalisierung auf Einzelspeicherzellen-Ebene möglich ist. Da ein Umsteuern von fehlerhaften Einzelspeicherzellen auf redundante Einzelspeicherzellen sehr aufwendig ist, ist eine Adreßmatrix in Form einer Fehleradreßmatrix in der Regel nur für Fehleranalysen sinnvoll. Sind, wie in Figur 6 gezeigt, beispielsweise 16 Vergleicherausgänge M00 ... M33 zu vier Quadrupeln M0 ... M3 gruppiert (Testbitmuster mit 4 Bit Wortbreite) aber auf Einzelspeicherzellenebene verknüpft, so sind minimal 1d (16) = 4 Paare von Wired-OR-Leitungen PTB0, PTB0N ... PTB3, PTB3N zur eindeutigen Ermittlung einer Fehleradresse erforderlich. Die Paare von Wired-OR-Leitungen sind über n-Kanal-Schalttransistoren T1A, T1B ... T4A, T4B mit Bezugspotential verbindbar, wobei die Gates dieser Schalttransistoren mit einer Steuerleitung ATDTP verbunden sind. Jeweils eine Leitung, beispielsweise Leitung PTBm, eines Paares von Wired-OR-Leitungen PTBm, PTBmN ist eine Eins-Leitung und die andere Leitung ist eine Null-Leitung. Ein Vergleicherausgang, zum Beispiel M0, ist nun über 1d (16) = 4 p-Kanal-Schalttransistoren, zum Beispiel T000 ... T003, gemäß eines eindeutig zugeordneten Binärkodes, zum Beispiel 0000, nur mit Null-Leitungen PTBmN verknüpft, wobei Verknüpfungen dadurch erfolgen, daß ein Vergleicherausgang mit den Gates, eine Versorgungsspannung V mit den Sourceanschlüssen und Wired-OR-Leitungen mit den Drainanschlüssen der vier p-Kanal-Schalttransistoren verbunden sind. Ein weiterer Vergleicherausgang M01 ist dann beispielsweise einem Binärkode 0001 zugeordnet und im Unterschied zum Vergleicherausgang M00 ist jetzt der Source-Anschluß des p-Kanal-Schalttransistors T010 nicht mit der Null-Leitung sondern mit der Eins-Leitung verbunden und nur die Transistoren T011 ... T013 sind, wie die Transistoren T00 ... T003, mit den Null-Leitungen verbunden. In entsprechender Weise sind alle Vergleicherausgänge M00 ... M33 gemäß ihrem zugeordneten Binärkode über Transistoren mit Eins-Leitungen und/oder Null-Leitungen verknüpft. Für eine Fehleradreßmatrix zur Verknüpfung von 16 Vergleicherausgängen sind 1d (16) = 4 Paare von Wired-OR-Leitungen, 2* 1d (16) = 8 n-Kanal-Schalttransistoren T1A ... T4D und 16 * 1d (16) = 64 p-Kanal-Schalttransistoren T000 ... T333 erforderlich.

Liegt auf der Steuerleitung ATDTP High-Potential an, so werden die n-Kanal-Schalttransistoren T1A ... T4B leitend und es stellt sich Low-Potential sowohl auf den Eins-Leitungen als auch auf den Null-Leitungen ein, da sich die gegebenenfalls aufgeladenen Wired-OR-Leitungen auf Bezugspotential entladen können. Liefert beispielsweise der Vergleicherausgang M01 Low-Potential, so stimmen Testbit und ausgelesenes Bit nicht überein und es liegt ein Fehler vor. Durch das Low-Potential an den Gates der p-Kanal-Schalttransistoren T010 ... T013 werden diese leitend, wodurch die Eins-Leitung PTB0 und die Null-Leitung PTB1N ... PTB3N auf High-Potential gelegt werden, was einer Fehleradresse 0001 entspricht. Jede Fehleradresse ungleich 0000 bedeutet, daß mindestens eine fehlerhafte Einzelspeicherzelle vorliegt. Ist eine Fehleradresse gleich 0000, so kann dies bedeuten, daß keine fehlerhafte Einzelspeicherzelle vorliegt oder daß die Einzelspeicherzelle mit der Fehleradresse 0000 fehlerhaft ist. Da mit 4 Bit nur 16 Zustände eindeutig gekennzeichnet werden können und 16 Einzelspeicherzellen fehlerhaft sein können, muß beispielsweise ein weiteres Bit für den fehlerfreien Fall vorgesehen werden. Ist sichergestellt, daß ein Einzelfehler (nur eine Einzelspeicherzelle der 16 Einzelspeicherzellen ist fehlerhaft) vorliegt, so gibt die Fehleradresse eindeutig die Adresse der fehlerhaften Einzelspeicherzelle an. Treten mehrere fehlerhafte Einzelspeicherzellen auf, so ergibt sich die Fehleradresse auf einer bitweisen ODER-Verknüpfung von Einzelfehleradressen und die Fehleradresse ist in diesem Fall stets ungleich 0000.

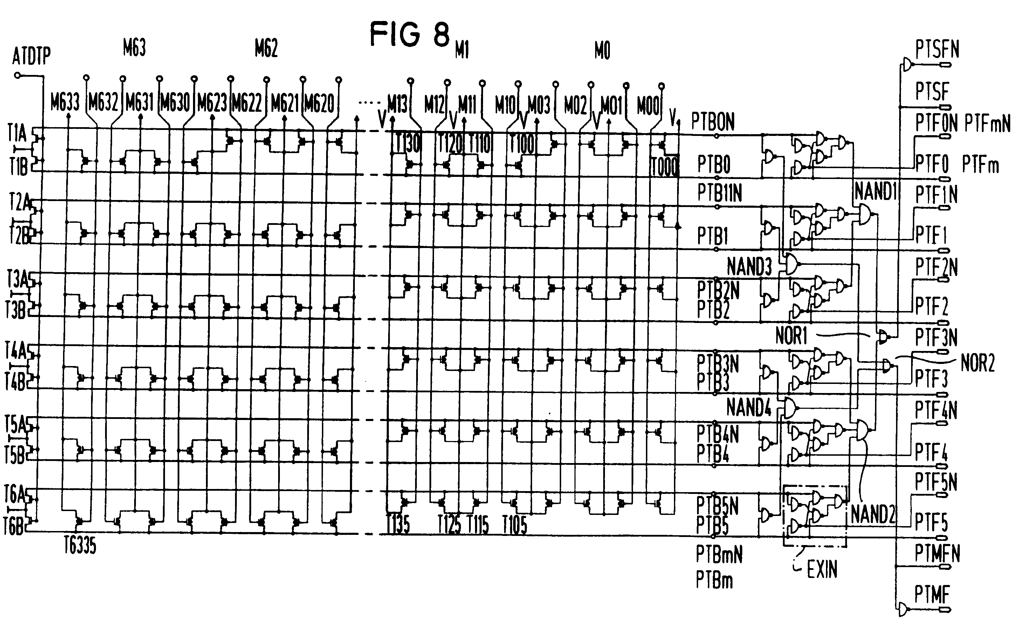

Figur 7 zeigt ein Schaltbild einer erfindungsgemäßen Schaltungsanordung, die eine Fehlertyperkennungsschaltung mit Einzelfehlererkennung bei gleichzeitiger Invertierung eines Fehleradreßsignals beinhaltet. Dabei sind beispielsweise Eingänge für vier Paare von Wired-OR-Leitungen PTB0, PTB0N ... PTB3, PTB3N und vier Paare von Fehleradreßausgängen PTF0, PTF0N ... PTF3, PTF3N vorgesehen, wobei jeweils eine Leitung, beispielsweise PTBm, eines Paares PTBm, PTBmN von Wired-OR-Leitungen direkt mit einem Ausgang eines Paares von Fehleradreßausgängen PTFm, PTFmN verbunden ist und jeweils der andere Ausgang des Paares von Fehleradreßausgängen über einen Inverter, beispielsweise IA, mit der Leitung, beispielsweise PTBm, des Paares von Wired-OR-Leitungen verbunden ist. Das Paar von Wired-OR-Leitungen PTB3, PTB3N ist beispielsweise durch eine Schaltung EXIN verknüpft, ist ausgangsseitig mit dem Paar von Fehleradreßausgängen PTF3, PTF3N verbunden und liefert ein Eingangssignal EX3 für eine NAND-Schaltung NAND. In gleicher Weise sind die Paare von Wired-OR-Leitungen PTB0, PTB0N ... PTB2, PTB2N verknüpft und liefern weitere Eingangssignale EX0 ... EX2 für die NAND-Schaltung NAND. Der Ausgang der NAND-Schaltung NAND ist über einen Inverter mit dem Einzelfehlerausgang PTSF verbunden und ist direkt mit einem Ausgang PTSFN verbunden, der das invertierte Signal des Einzelfehlerausgangs führt. Die Schaltung EXIN stellt eine EXOR-Schaltung dar, die aus zwei Invertern IA, IB und drei 2-fach NAND-Gliedern N1 ... N3 aufgebaut ist. Das Signal der Leitung PTB3N ist hierzu beispielsweise mit dem durch den Inverter IA invertierten Signal der Leitung PTB3 durch das NAND-Glied N1 verknüpft, das Signal der Leitung PTB3 ist mit dem durch den Inverter IB invertierten Signal der Leitung PTB3N durch das NAND-Glied N2 verknüpft und die Ausgänge der beiden NAND-Glieder N1 und N2 bilden die Eingänge eines weiteren NAND-Gliedes N3, das am Ausgang EX3 eine EXOR-Verknüpfung der Signale der Leitungen PTB3, PTB3N liefert. Ein Vorteil der Schaltung EXIN ist, daß der Inverter IA zur Bildung eines invertierten Fehlerausgangssignals nutzbar ist.

Da bei einer Adreßbildung nicht einzelne Wired-OR-Leitungen sondern Paare von Wired-OR-Leitungen (Null- und Eins-Leitungen) benützt werden, können zusätzliche Informationen wie zum Beispiel Fehlerfreiheit, Einzelfehler und Mehrfachfehler durch logische Verknüpfungen aus Null- und Eins-Leitungen gebildet werden. Tritt ein Einzelfehler auf, so werden auf Low-Potential entladene Paare von Wired-OR-Leitungen PTBm, PTBmN gemäß der Fehleradresse teilweise mit High-Potential verbunden. In einer der Fehlertyperkennungsschaltung vorgeschalteten Adreßmatrix wird ein gleicher Ausgang über p-Kanal-Schalttransistoren entweder mit einer Null-Leitung oder mit einer Eins-Leitung gemäß der Einzelfehleradresse verknüpft. Daraus folgt, daß sich im Einzelfehlerfall die Signale aller Null-Leitungen PTBmN von den Signalen der jeweils zugehörigen Eins-Leitungen PTBm unterscheiden müssen. Zur Ermittlung eines Einzelfehlers wird deshalb jeweils eine Null-Leitung mit der zugehörigen Eins-Leitung EXOR-verknüpft und die EXOR-Verknüpfungsausgänge (EX0 ... EX3) durch eine UND-Schaltung zusammengefaßt, da dies bei allen Paaren von Wired-OR-Leitungen gleichzeitig erfüllt sein muß.

In Figur 8 ist ein Schaltbild einer Schaltungsanordnung, die eine Redundanzmatrix mit Paaren von Wired-OR-Leitungen BTPm, PBTmN und eine nachgeschalteten Fehlertyp erkennungsschaltung mit Einzel- und Mehrfachfehlererkennung bei gleichzeitiger Invertierung eines Fehleradreßsignals beinhaltet. Die Redundanzadreßmatrix unterscheidet sich von einer Fehleradreßmatrix dadurch, daß die Fehlerlokalisierung nicht auf Einzelspeicherzellen-Ebene erfolgt, sondern nur fehlerhafte Speicherzellen-n-Tupel ermittelbar und dann auf redundante und fehlerfreie Speicherzellen-n-Tupel umsteuerbar sind. Sind beispielsweise, wie in Figur 8 gezeigt, 256 Vergleicherausgänge M00 ... M633 zu 64 Quadrupeln M0 ... M63 gruppiert (Testmuster mit 4 Bit Wortbreite) und quadrupelweise verknüpft, so sind minimal ld (256/4) = 6 Paare von Wired-OR-Leitungen PTB0, PTB0N ... PTB5, PTB5N zur Ermittlung einer Fehleradresse erforderlich. Die Paare von Wired-OR-Leitungen sind über n-Kanal-Schalttransistoren T1A, T1B ... T6A, T6B mit Bezugspotential verbindbar, wobei die Gates dieser Schalttransistoren mit einer Steuerleitung ATDTP verbunden sind. Jeweils eine Leitung, beispielsweise Leitung PTBm, eines Paares von Wired-OR-Leitungen PTBm, PTBmN ist eine Eins-Leitung und die andere Leitung ist eine Null-Leitung. Ein Quadrupel von Vergleicherausgängen, zum Beispiel M1, ist nun über 4 * 1d (256/4) = 24 p-Kanal-Schalttransistoren T100 ... T105, T110 ... T115, T120 ... T125 und T130 ... T135 gemäß eines eindeutig zugeordneten Binärkodes, zum Beispiel 000 001, mit einer Einzelleitung PTB0 und 5 Null-Leitungen PTB1N ... PTB5N verknüpft, wobei Verknüpfungen dadurch erfolgen, daß jeweils ein Vergleicherausgang mit den Gates, eine Versorgungsspannung V mit den Drainanschlüssen und die Wired-OR-Leitungen mit den Source-Anschlüssen von jeweils ld (256/4) = 6 p-Kanal-Schalttransistoren verbunden sind. Die vier Vergleicherausgänge eines Quadrupels von Vergleicherausgängen sind gemäß ihrer gemeinsamen Quadrupeladresse gleichartig mit Null- und Eins-Leitungen verknüpft. In entsprechender Weise sind alle Vergleicherausgänge M00 bis M633 gemäß einem eindeutig zugeordneten Binärkode über Transistoren mit Eins-Leitungen und/oder Null-Leitungen verknüpft. Für eine Redundanzadreßmatrix zur Verknüpfung von 64 Quadrupeln von Vergleicherausgängen sind ld (256/4) = 6 Paare von Wired-OR-Leitungen, 2 * 1d (256/4) = 12 n-Kanal-Schalttransistoren T1A ... T6B und 256 * 1d (256/4) = 1536 p-Kanal-Schalttransistoren T000 ... T6335 erforderlich.

Die der Redundanzadreßmatrix nachgeschaltete Fehlertyp-Erkennungsschaltung ist eingangsseitig mit den sechs Paaren von Wired-OR-Leitungen verbunden und ausgangsseitig sind sechs Paare von Redundanzadreßausgängen PTF0, PTF0N ... PTF5, PTF5N vorgesehen, wobei jeweils eine Leitung, beispielsweise PTBm, eines Paares von Redundanzadreßausgängen PTFm, PTFmN verbunden ist und jeweils der andere Ausgang des Paares von Redundanzadreßausgängen über einen Inverter mit der anderen Leitung, beispielsweise PTBm, des Paares von Wired-OR-Leitungen verbunden ist. Zur Bildung eines Einzelfehlersignals sind, wie in der Beschreibung von Figur 7 bereits erläutert, jeweils die beiden Leitungen eines Paares von Wired-OR-Leitungen EXOR-verknüpft und die Ausgänge der EXOR-Verknüpfungen durch eine UND-Verknüpfung zusammengefaßt, die ausgangsseitig mit einem Einzelfehlerausgang PTSF verbunden ist. Eine EXOR-Inverter schaltung einer EXIN aus zwei Invertern und drei NAND-Gliedern liefert, wie bei Figur 7, sowohl eine Inverterfunktion zur Invertierung eines Adreßausgangs als auch eine EXOR-Verknüpfung eines Paares von Wired-OR-Leitungen. Die sechs Paare von Wired-OR-Leitungen sind durch EXOR-Inverterschaltungen EXIN EXOR-verknüpft. Eine UND-Verknüpfung der EXOR-Verknüpfungsausgänge erfolgt durch zwei-dreifach NAND-Glieder NAND1 und NAND2, deren Ausgänge durch ein zweifach NOR-Glied NOR1 verknüpft sind, wobei das NOR-Glied ausgangsseitig direkt mit einem Einzelfehlerausgang PTSF und über einen Inverter mit einem invertierten Einzelfehlerausgang PTSFN verbunden ist. Da nur ein zusätzlicher Ausgang, wie zum Beispiel der Einzelfehlerausgang, die Entscheidung erlaubt ob eine Fehleradresse 000 000 oder Fehlerfreiheit vorliegt, sind minimal ld (256/4) + 1 = 7 Ausgänge für eine eindeutige Aussage erforderlich.

Zusätzlich zu einer erforderlichen Einzelfehlererkennungsschaltung weist die in Figur 8 gezeigte Fehlertyperkennungsschaltung einen Mehrfachfehlerausgang PTMF auf, der gegebenenfalls zur Entlastung eines Prüfautomaten dienen kann. Wenn jeweils beide Leitungen eines Paares von Wired-OR-Leitungen Low-Signal führen so liegt Fehlerfreiheit vor, wenn jeweils beide Leitungen alle Paare von Wired-OR-Leitungen zueinander unterschiedliches Signal führen liegt ein Einzelfehler vor und wenn bei mindestens einem Paar von Wired-OR-Leitungen beide Leitungen High-Signal führen so liegen mindestens zwei Fehler, also ein Mehrfachfehler vor. Daraus folgt, daß beide Leitungen eines Paares von Wired-OR-Leitungen jeweils durch ein UND-Glied zu verknüpfen sind und daß die Ausgänge der UND-Glieder durch ein ODER-Glied zu einem Mehrfachfehlerausgang zusammenzufassen sind. In der in Figur 8 dargestellten Schaltungsanordnung wird dies dadurch erreicht, daß jeweils beide Leitungen eines Paares von Wired-OR-Leitungen durch 2-fach NAND-Glieder verknüpft sind, die Ausgänge der 2-fach NAND-Glieder durch zwei 3-fach-NAND-Glieder NAND3 und NAND4 verknüpft sind und die Ausgänge der 3-fach-NAND-Glieder durch ein 2-fach-NOR-Glied NOR2 verknüpft sind, wobei der Ausgang des 2-fach-NOR-Gliedes über einen Inverter mit dem Mehrfachfehlerausgang PTMF und direkt mit einem invertierten Mehrfachfehlerausgang PTMFN verbunden ist.

Wird die Steuerleitung ATDTP mit High-Potential (Reset) beaufschlagt, so werden die n-Kanal-Schalttransistoren T1A ... T6B leitend und die Paare von Wired-OR-Leitungen erhalten Low-Potential, da sie mit Bezugspotential verbunden werden. Nachdem ein Reset erfolgt ist, erhält die Steuerleitung ATDTP Low-Potential und an den Vergleicherausgängen M00 ... M633 stehen gültige Vergleicherergebnisse zur Verfügung. Tritt ein Fehler in einem Speicherzellenquadrupel auf, das einem Quadrupel von Vergleicherausgängen M1 zugeordnet ist, so werden entweder sechs, zwölf, achtzehn oder vierundzwanzig Transistoren, zum Beispiel der 24 Transistoren T100 ... T135, leitend und verbinden die Null-und Eins-Leitungen der Paare von Wired-OR-Leitungen gemäß dem jeweiligen Binärkode, der den Speicherzellenquadrupeln zugeordnet ist, mit der Versorgungsspannung V (High-Potential). Liefern zum Beispiel die Vergleicherausgänge M10 und M11 Low-Potential (Fehler), so werden in beiden Fällen, gemäß der gemeinsamen Quadrupeladresse M1, die gleichen Null- und Eins-Leitungen auf High-Potential gelegt und die Fehlertyperkennungsschaltung erkennt dies als Einzelfehler, da nur ein einzelnes Speicherzellenquadrupel fehlerhaft ist. Liefern jedoch beispielsweise die Vergleicherausgänge M00 und M10, die unterschiedlichen Quadrupeln M0 und M1 angehören, ein Low-Signal, so werden beispielsweise die Transistoren T000 und T100 leitend und sowohl die Null-Leitung PTB0N als auch die Eins-Leitung PTB0 erhalten High-Potential. Die NAND-Verknüpfung der Leitungen PTB0 und PTB0N liefert Low-Potential, das 3-fach NAND-Glied NAND3 liefert am Ausgang High-Potential, da mindestens ein Eingang Low-Potential aufweist und das NOR-Glied NOR1 liefert Low-Potential, was durch einen Inverter am Mehrfachfehlerausgang PTMF zu High-Potential wird. Da sich die Signale der Leitungen PTB0 und PTB0N nicht mehr unterscheiden liefert die EXOR-Verknüpfung der Einzelfehlererkennung Low-Potential, der Ausgang von NAND1 erhält High-Potential und der Ausgang von NOR1 und damit auch PTSF erhalten Low-Potential (kein Einzelfehler).

Die getroffenen Aussagen gelten auch für eine Schaltungsanordnung, die anstelle von n-Kanal-Schalttransistoren p-Kanal-Schalttransistoren und anstelle von p-Kanal-Schalttransistoren n-Kanal-Schalttransistoren besitzt und deren Versorgungsspannungspolarität in entsprechender Weise angepaßt ist.

## Patentansprüche

1. Schaltungsanordnung zum Testen eines Halbleiterspeichers mittels Paralleltests mit verschiedenen Testbitmustern,
bei der beliebige n-Tupel von Testbits in mindestens ein n-Bit breites Register (REG) einschreibbar sind, bei der jeweils das im Register (REG) befindliche n-Tupel von Testbits über Datenleitungen (DL, DLi') des Halbleiterspeichers in eine Vielzahl von Speicherzellen-n-Tupel (NSPZ) mit gemeinsamer Wortleitung (WL) einschreibbar ist, bei der jeweils das im Register (REG) befindliche n-Tupel von Testbits einer Vielzahl von Vergleicherschaltungen (MC) zuführbar ist,
bei der Bitmuster der Speicherzellen-n-Tupel mit gemeinsamer Wortleitung über Datenleitungen (DLi', DL, DLi) des Halbleiterspeichers auslesbar und mit den n-Tupeln von Testbits in der Vielzahl von Vergleicherschaltungen (MC) vergleichbar sind,
und bei der Vergleicherausgänge (Mik) der Vielzahl von Vergleicherschaltungen (MC) durch Wired-OR-Leitungen (PTB) zusammengefaßt sind,
**dadurch gekennzeichnet,**
- daß die Vergleicherausgänge (Mik) der Vielzahl von Vergleicherschaltungen (MC) durch Paare von Wired-OR-Leitungen (PTBm, PTBmN) zu einer Adreßmatrix (AM) zusammengefaßt sind und jeweils ein Paar von Wired-OR-Leitungen einem Adreßbit entspricht,
- daß jeweils ein Paar von Wired-OR-Leitungen aus einer Null-Leitung für den Zustand Adreßbit gleich 0 und einer Eins-Leitung für den Zustand Adreßbit gleich 1 besteht,
- daß alle Wired-OR-Leitungen durch Schalttransistoren (T1A ... T6B) eines ersten Leitungstyps (n) zu einer auf Bezugspotential befindlichen Leitung durchschaltbar sind, um sie vor einem jeweiligen Test zu entladen,
- daß durch jeden Vergleicherausgang entweder die Null-Leitung oder die Eins-Leitung jedes Paares von Wired-OR-Leitungen über einen zugehörigen Schalttransistor (T000 ... T6335) eines zweiten Leitungstyps (p) auf eine Versorgungsspannung (V) durchschaltbar ist,
- daß die Kombination der durchgeschalteten Eins- und Null-Leitungen entweder für alle Vergleicherausgänge oder für alle n-Tupel von Vergleicherausgängen unterschiedlich ist und
- daß jeweils eine Leitung (beispielsweise PTBm) der Paare von Wired-OR-Leitungen (PTBm, PTBmN) mit einem Adreßausgang (PTFm) verbunden ist.

2. Schaltungsanordnung nach Anspruch 1,
**dadurch gekennzeichnet,**
daß die Adreßmatrix (AM) als Fehleradreßmatrix ausgebildet ist, um fehlerhafte Einzelspeicherzellen (SPZ) zu lokalisieren, daß dabei jedem Vergleicherausgang (beispielsweise M01) eindeutig ein Binärkode (beispielsweise 0001) zugeordnet ist und daß die Versorgungsspannung (V) über Schalttransistoren (beispielsweise T010 ... T013) des zweiten Leitungstyps zu der dem jeweiligen Binärkode (beispielsweise 0001) entsprechenden Kombination aus Eins-Leitungen (beispielsweise PTB0) und Null-Leitungen (beispielsweise PTB1N.. . PTB3N) durchschaltbar ist.

3. Schaltungsanordnung nach Anspruch 1,
**dadurch gekennzeichnet**,
daß die Adreßmatrix (AM) als Redundanzadreßmatrix ausgebildet ist, um fehlerhafte Speicherzellen- n-Tupel (NSPZ) zu lokalisieren, daß dabei jedem n-Tupel von Vergleicherausgängen (beispielsweise M1) eindeutig ein Binärkode (beispielsweise 000 001) zugeordnet ist und daß die Versorgungsspannung (V) über Schalttransistoren (T100 ... T136) des zweiten Leitungstyps zu der dem jeweiligen Binärkode (beispielsweise 000 001) entsprechenden Kombination aus Eins-Leitungen (beispielsweise PTB0) und Null-Leitungen (beispielsweise PTB1N... PTB5N) durchschaltbar ist.

4. Schaltungsanordnung nach Anspruch 1,
**dadurch gekennzeichnet,**
daß die Paare von Wired-OR-Leitungen (PTBm, PTBmN) mit Eingängen einer Fehlertyperkennungsschaltung (FTE) verbunden sind.

5. Schaltungsanordnung nach Anspruch 4,
**dadurch gekennzeichnet,**
daß die Fehlertyperkennungsschaltung (FTE) einen Schaltungsteil zur Erkennung von Einzelfehlern enthält, daß dieser Schaltungsteil die Paare von Wired-OR-Leitungen (PTBm, PTBmN) jeweils einer EXOR-Verknüpfung zuführt und daß die Ausgänge der EXOR-Verknüpfung durch eine UND-Verknüpfung zusammengefaßt sind, die ausgangsseitig mit einem Einzelfehlerausgang (PTSF) verbunden ist.

6. Schaltungsanordnung nach Anspruch 5,
**dadurch gekennzeichnet,**
daß die EXOR-Verknüpfungen der Fehlertyperkennungs schaltung (FTE) durch eine Schaltung (EXIN) mit drei 2-fach-NAND-Gattern (N1, N2 und N3) und zwei Invertern (IA und IB) realisiert ist.

7. Schaltungsanordnung nach Anspruch 4,
**dadurch gekennzeichnet,**
daß die Fehlertyperkennungsschaltung (FTE) einen Schaltungsteil zur Erkennung von Mehrfachfehlern enthält, daß dieser Schaltungsteil die Paare von Wired-OR-Leitungen (PTBm, PTBmN) jeweils einer UND-Verknüpfung zuführt und daß die Ausgänge der UND-Verknüpfungen durch eine ODER-Verknüpfung zusammengefaßt sind, die ausgangsseitig mit einem Mehrfachfehlerausgang (PTMF) verbunden ist.

8. Schaltungsanordnung nach Anspruch 1,
**dadurch gekennzeichnet,**
daß mindestens eine Vergleicherschaltung als Paritätsdreher- Schaltung (PD) mit vier Schalttransistoren (4, 5, 6, 7) und einem Differenzverstärker (3) aufgebaut ist,
daß das Gate eines ersten Schalttransistors (4) mit einem ersten Ausgang eines Registerausgangspaares (TPB3,3N) verbunden ist und eine erste Leitung eines Datenleitungspaares (DLi3,3N) durch den ersten Schalttransistor (4) auf einen invertierenden Eingang (1) des Differenzverstärkers (3) durchschaltbar ist,
daß das Gate eines zweiten Schalttransistors (5) mit dem zweiten Ausgang eines Registerausgangspaares (TPB3,3N) verbunden ist und die erste Leitung des Datenleitungspaares (DLi3,3N) durch den zweiten Schalttransistor (5) auf den nicht invertierenden Eingang (2) des Differenzverstärkers (3) durchschaltbar ist,
daß das Gate eines dritten Transistors (6) mit dem zweiten Ausgang des Registerausgangspaares (TPB3,3N) verbunden ist und die zweite Leitung des Datenleitungspaares (DLi3,3N) durch den dritten Schalttransistor (6) auf den invertierenden Eingang (1) des Differenzverstärkers (3) durchschaltbar ist,
daß das Gate des vierten Schalttransistors (7) mit dem ersten Ausgang des Registerausgangspaares (TPB3,3N) verbunden ist und die zweite Leitung des Datenleitungspaares (DLi3,3N) durch den vierten Schalttransistor (7) auf den nicht invertierenden Eingang (2) des Differenzverstärkers (3) durchschaltbar ist,
daß bei den Registerausgangspaaren jeweils der zweite Ausgang das invertierte Signal des ersten Ausgangs und bei den Datenleitungspaaren jeweils die zweite Leitung das invertierte Signal der ersten Leitung führt,
daß beim Test einer Speicherzelle die erste Leitung (DLi3) des Datenleitungspaares (DLi3,3N) das gleiche logische Signal führt wie der zweite Ausgang (TPB3) des Registerausgangspaares (TPB3,3N), wenn das eingeschriebene Testbit der Speicherzelle mit dem ausgelesenen Bit der Speicherzelle übereinstimmt
und daß ein Vergleicherausgang (Mi3) mit dem Ausgang des Differenzverstärkers (3) verbunden ist.

## Claims

1. Circuit arrangement for testing a semiconductor memory by means of parallel tests using various test bit patterns, in which any n-tuples of test bits can be written into at least one n-bit long register (REG), in which, in each case, the n-tuple of test bits located in the register (REG) can be written via data lines (DL, DLi') of the semiconductor memory into a multiplicity of memory cell n-tuples (NSPZ) having a common word line (WL), in which in each case the n-tuple of test bits located in the register (REG) can be supplied to a multiplicity of comparator circuits (MC), in which the bit patterns of the memory cell n-tuples having a common word line can be read out via data lines (DLi', DL, DLi) of the semiconductor memory and with which the n-tuples of test bits can be compared in the multiplicity of comparator circuit. (MC), and in which the comparator outputs (Mik) of the multiplicity of comparator circuits (MC) are combined by wired-OR lines (PTB), characterised in that the comparator outputs (Mik) of the multiplicity of comparator circuits (MC) are combined by pairs of wired-OR lines (PTBm, PTBmN) to form an address matrix (AM) and a pair of wired-OR lines corresponds to an address bit in each case, in that in each case one pair of wired-OR lines comprises a zero-line for the state where the address bit is 0, and a one-line for the state where the address bit is 1, in that all the wired-OR lines can be switched through to a line which is at reference potential by means of switching transistors (T1A..T6B) of a first conductance type (n), in order to discharge them before a respective test, in that either the zero-line or the one-line of each pair of wired-OR lines can be switched through, by means of each comparator output, via an associated switching transistor (T000...T6335) of a second conductance type (p) to a supply voltage (V), in that the combination of the switched-through one-lines and zero-lines differs either for all the comparator outputs or for all the n-tuples of comparator outputs, and in that in each case one line (for example PTBm) of the pairs of wired-OR lines (PTBm, PTBmN) is connected to an address output.

2. Circuit arrangement according to Claim 1, characterised in that the address matrix (AM) is constructed as a fault address matrix, in order to locate faulty individual memory cells (SPZ), in that for this purpose a binary code (for example 0001) is assigned unambiguously to each comparator output (for example M01), and in that the supply voltage (V) can be switched through to the combination of one-lines (for example PTB0) and zero-lines (for example PTB1N ... PTB3N) corresponding to the relevant binary code (for example 0001), via switching transistors (for example T010 ... T013) of the second conductance type.

3. Circuit arrangement according to Claim 1, characterised in that the address matrix (AM) is constructed as a redundant address matrix, to locate faulty memory cell n-tuples (NSPZ), in that for this purpose a binary code (for example 000 001) is assigned unambiguously to each n-tuple of comparator outputs (for example M1), and in that the supply voltage (V) can be switched through to the combination of one-lines (for example PTB0) and zero-lines (for example PTB1N ... PTB5N) corresponding to the relevant binary code (for example 000 001), via switching transistors (T100 ... T136) of the second conductance type.

4. Circuit arrangement according to Claim 1, characterised in that the pairs of wired-OR lines (PTBm, PTBmN) are connected to the inputs of a fault type identification circuit (FTE).

5. Circuit arrangement according to Claim 4, characterised in that the fault type identification circuit (FTE) contains a circuit element for identifying individual faults, in that this circuit element feeds the pairs of wired-OR lines (PTBm, PTBmN) in each case to an EXOR-link, and in that the outputs of the EXOR-link are combined by an AND-link, the output of which is connected to an individual-fault output (PTSF)

6. Circuit arrangement according to Claim 5, characterised in that the EXOR-links in the fault type identification circuit (FTE) are implemented by means of a circuit (EXIN) having three double NAND-gates (N1, N2 and N3) and two invertors (IA and IB)

7. Circuit arrangement according to Claim 4, characterised in that the fault type identification circuit (FTE) contains a circuit element for identifying multiple faults, in that this circuit element feeds the pairs of wired-OR lines (PTBm, PTBmN) in each case to an AND-link, and in that the outputs of the AND-links are combined by an OR-link, whose output is connected to a multiple-fault output (PTMF)

8. Circuit arrangement according to Claim 1, characterised in that at least one comparator circuit is constructed as a parity inverting circuit (PD) having four switching transistors (4, 5, 6, 7) and a differential amplifier (3), in that the gate of a first switching transistor (4) is connected to a first output of a register output pair (TPB3,3N) and a first line of a data line pair (DLi3,3N) can be switched through to an inverting input (1) of the differential amplifier (3) by means of the first switching transistor (4), in that the gate of a second switching transistor (5) is connected to the second output of a register output pair (TPB3,3N) and the first line of the data line pair (DLi3,3N) can be switched through to the non-inverting input (2) of the differential amplifier (3) by means of the second switching transistor (5), in that the gate of a third transistor (6) is connected to the second output of the register output pair (TPB3,3N) and the second line of the data line pair (DLi3,3N) can be switched through to the inverting input (1) of the differential amplifier (3) by means of the third switching transistor (6), in that the gate of the fourth switching transistor (7) is connected to the first output of the register output pair (TPB3,3N) and the second line of the data line pair (DLi3,3N) can be switched through to the non-inverting input (2) of the differential amplifier (3) by means of the fourth switching transistor (7), in that in the case of the register output pairs, the second output in each case carries the inverted signal of the first output and in the case of the data line pairs, the second line in each case carries the inverted signal of the first line, in that during testing of a memory cell, the first line (DLi3) of the data line pair (DLi3,3N) carries the same logic signal as the second output (TPB3) of the register output pair (TPB3,3N), if the test bit written into the memory cell corresponds to the bit read out of the memory cell, and in that one comparator output (Ni3) is connected to the output of the differential amplifier (3)

## Revendications

1. Montage pour tester une mémoire à semiconducteurs au moyen de tests en parallèle à l'aide de différents profils binaires de test, dans lequel
des nuplets quelconques de bits de test peuvent être enregistrés dans au moins un registre (REG) d'une largeur de n bits,
le nuplet de bits de test, qui est situé dans le registre (REG), peut être enregistré, par l'intermédiaire de lignes de transmission de données (DL, DLi') de la mémoire à semiconducteurs, dans une multiplicité de nuplets de cellules de mémoire (NSPZ) avec une ligne commune de transmission de mots (WL),
le nuplet de bits de test, qui est situé dans le registre (REG), peut être envoyé à une multiplicité de circuits comparateurs (MC),
le profil binaire des nuplet de cellules de mémoire munies de la ligne de transmission de mots commune peut être lu, par l'intermédiaire de lignes de transmission de données (DLi', DLi) de la mémoire à semiconducteurs, et peut être comparé aux nuplets de bits de test, dans la multiplicité de circuits comparateurs (MC), et
des sorties (Mik) de la multiplicité de circuits comparateurs (MC) sont réunies par des lignes (PTB) reliées selon la combinaison OU câblé,
caractérisé par le fait
- que les sorties (Mik) de la multiplicité de circuits comparateurs (MC) sont réunies, par des couples de lignes (PTBm, PTBmN) reliées selon la combinaison OU câblé, à une matrice d'adresses (AM) et respectivement un couple de lignes reliées selon la combinaison OU correspond à un bit d'adresse,
- qu'un couple de lignes reliées selon la combinaison OU câblé est constitué d'une ligne de transmission de zéro pour l'état du bit d'adresse égal à 0, et par une ligne de transmission de un pour l'état du bit d'adresse égal à 1,
- que toutes les lignes reliées selon la combinaison OU câblé peuvent être interconnectées, par des transistors de commutation (T1A, T6B) d'un premier type de conductivité (n), à une ligne placée à un potentiel de référence, de manière qu'elles se déchargent avant un test respectif,
- que soit la ligne de transmission de zéro, soit la ligne de transmission de un de chaque couple de lignes reliées selon la combinaison OU câblé peut être interconnectée, par chaque sortie de comparateur, à une tension d'alimentation (V), par l'intermédiaire d'un transistor de commutation associé (T000...T6335) d'un second type de conductivité (p),
- que la combinaison des lignes interconnectées de transmission de un et de zéro est différente soit pour toutes les sorties des comparateurs, soit pour tous les nuplets de sortie des comparateurs, et
- que respectivement une ligne (par exemple PTBm) des couples de lignes (PTBm, PTBmN) reliées selon la combinaison OU câblé est reliée à une sortie d'adresses (PTFm).

2. Montage suivant la revendication 1,
caractérisé par le fait que la matrice d'adresses (AM) est agencée sous la forme d'une matrice d'adresses d'erreurs, afin de localiser des cellules individuelles de mémoire (SPZ) défectueuses, qu'un code binaire (par exemple 0001) est associé de façon nette à chaque sortie (par exemple M01) d'un comparateur, et que la tension d'alimentation (V) peut être interconnectée, par l'intermédiaire de transistors de commutation (par exemple T010...T013) du second type de conductivité, à la combinaison, correspondant au code binaire respectif (par exemple 0001), de lignes de transmission de un (par exemple PTB0) et de lignes de transmission de zéro (par exemple PTB1N...PTB3N).

3. Montage suivant la revendication 1,
caractérisé par le fait que la matrice d'adresses (AM) est agencée sous la forme d'une matrice d'adresses redondante, afin de localiser des nuplets (NPZ) défecteux de cellules de mémoire, qu'à chaque nuplet des sorties (par exemple M1) de comparateur est associé de façon nette un code binaire (par exemple 000 001) et que la tension d'alimentation (V) peut être appliquée directement, par l'intermédiaire de transistors de commutation (T100...T136) du second type de conductivité, à la combinaison, correspondant au code binaire respectif (par exemple 000 001), de lignes de transmission de un (par exemple PTB0) et de lignes de transmission de zéro (par exemple PTB1N... PTB5N).

4. Montage suivant la revendication 1,
caractérisé par le fait que les couples de lignes (PTBm, PTBmN) reliées selon la combinaison OU câblé sont reliés à des entrées d'un circuit (FTE) d'identification de type d'erreurs.

5. Montage suivant la revendication 4,
caractérisé par le fait que le circuit (FTE) d'identification de type d'erreurs comporte une partie de circuit servant à identifier des erreurs individuelles, que cette partie de circuit relie les couples de lignes (PTBm, PTBmN) reliées selon la combinaison OU câblé à un circuit combinatoire OU-EXCLUSIF et que les sorties du circuit combinatoire OU-EXCLUSIF sont réunies par un circuit combinatoire ET, qui est relié, côté sortie, à une sortie (PTSF) d'erreur individuelle.

6. Montage suivant la revendication 5, caractérisé par le fait que les circuits combinatoires OU-EXCLUSIF du circuit (FTE) d'identification de type d'erreurs sont formés par un circuit (EXIN) comportant trois portes NON-ET doubles (N1, N2, N3) et deux inverseurs (IA et IB).

7. Montage suivant la revendication 4, caractérisé par le fait que le circuit (FTE) d'identification de type d'erreur comporte une partie de circuit servant à identifier des erreurs multiples, que cette partie de circuit relie les couples de lignes (PTBm, PTBmN) reliées selon la combinaison OU câblé respectivement à un circuit combinatoire ET, et
que les sorties des circuits combinatoires ET sont réunies par un circuit combinatoire OU, qui est relié, côté sortie, à une sortie (PTMF) d'erreurs multiples.

8. Montage suivant la revendication 1, caractérisé par le fait
qu'au moins un circuit comparateur est agencé sous la forme d'un circuit de rotation de polarité (PD) comportant quatre transistors de commutation (4, 5, 6, 7) et un amplificateur différentiel (3),
que la grille d'un premier transistor de commutation (4) est reliée à une première sortie d'un couple (TPB3, N3) de sorties de registres et qu'une première ligne d'un couple (DLi3, 3N) de lignes de transmission de données peut être interconnectée, par le premier transistor de commutation (4), à une entrée inverseuse (1) de l'amplificateur différentiel (3),
que la grille d'un deuxième transistor de commutation (5) est reliée à la seconde sortie d'un couple (TPB3, 3N) de sorties de registres et que la première ligne du couple (DLi3, 3N) de lignes de transmission de données peut être interconnectée, par le deuxième transistor de commutation (5), à l'entrée non inverseuse (2) de l'amplificateur différentiel (3),
que la grille d'un troisième transistor (6) est reliée à la seconde sortie du couple (TPB3, 3N) de sorties de registres et que la seconde ligne du couple (DLi3, 3N) de lignes de transmission de données peut être interconnectée, par le troisième transistor de commutation (6), à l'entrée inverseuse (1) de l'amplificateur différentiel (3),
que la grille du quatrième transistor de commutation (7) est reliée à la première sortie du couple (TPB3, 3N) de sorties de registres et que la seconde ligne du couple (TLi3, 3N) de lignes de transmission de données peut être interconnectée, par le quatrième transistor de commutation (7), à l'entrée non inverseuse (2) de l'amplificateur différentiel (3),
que, dans les couples de sorties de registre, la seconde sortie fournit le signal inversé de la première sortie et que, pour les couples de lignes de transmission de données, la seconde ligne fournit le signal inversé de la première ligne,
que, lors du test d'une cellule de mémoire, la première ligne (DLi3) du couple (DLi3, 3N) de lignes de transmission de données fournit, comme la seconde sortie (TPB3) du couple (TPB3, 3N) de sorties de registre, le même signal logique lorsque le bit de test enregistré de la cellule de mémoire coïncide avec le bit lu de la cellule de mémoire, et qu'une sortie (Mi3) du comparateur est reliée à la sortie de l'amplificateur différentiel (3).
